# EUROPÄISCHE PATENTSCHRIFT

(11) **EP 2 115 819 B1**
(45) Veröffentlichungstag und Bekanntmachung des Hinweises auf die Patenterteilung: **27.01.2016**
(21) Anmeldenummer: 07822811.1
(22) Anmeldetag: 22.11.2007
(51) Int. Cl.: H01H 1/04, H01H 1/40, H01H 19/58, H01R 12/52, H01R 12/57, H01R 13/03, H05K 3/24, H05K 3/32, H04R 1/10

(54) **KONTAKTSYSTEM**
CONTACT SYSTEM
SYSTÈME DE CONTACT

(30) Priorität: 31.01.2007 DE 102007004811
(43) Veröffentlichungstag der Anmeldung: 11.11.2009
(73) Patentinhaber: Gigaset Communications GmbH, 40549 Düsseldorf (DE)
(72) Erfinder: BUSCH, Georg, 48683 Ahaus (DE); HÜNTING, Ralf, 46395 Bocholt (DE); FELS, Christoph, 48653 Coesfeld (DE)
(74) Vertreter: Michalski Hüttermann & Partner Patentanwälte mbB
(86) Internationale Anmeldenummer: PCT/EP2007/062686
(87) Internationale Veröffentlichungsnummer: WO 2008/092520

(56) Entgegenhaltungen:
- EP-A- 1 447 846
- EP-A- 1 708 218
- WO-A-98/43317
- US-A- 4 625 084
- US-A1- 2005 087 363

## Beschreibung

Die Erfindung betrifft ein Kontaktsystem gemäß dem Oberbegriff des Anspruchs 1.

Derzeit sind insbesondere fünf Kontaktsysteme eingesetzt. Dabei wird zwischen lösbaren und unlösbaren Kontaktsystemen unterschieden.

Das kostengünstigste Kontaktsystem basiert auf einer Zinn-Feder, die auf einer Zinn-Leiterplattenoberfläche kontaktiert.

Weiter ist ein Kontaktsystem bekannt, das auf einer vergoldeten Feder basiert, die auf einer Nickel/Gold-Leiterplattenoberfläche kontaktiert.

Ferner ist ein mit Stecker und Buchse gebildetes Kontaktsystem bekannt, welches über ein Kabel an einem zum Beispiel Lautsprecher befestigt ist.

Daneben ist aus dem Dokument EP 1 708 218 A2 ein Kontaktsystem mit zumindest einer Kontaktfeder und einem auf die Kontaktfeder einwirkenden Schaltelement bekannt, wobei das Kontaktsystem einen der Kontaktfeder zugeordneten Gegenkontakt hat, der auf einer Leiterplatte aufgebracht ist und eine Karbonschicht aufweist.

Schließlich ist ein Kontaktsystem bekannt, das nicht lösbar ist, beispielsweise basierend auf einer Kontaktierung durch Verlöten.

Soweit nachfolgend von einer Gold-Feder gesprochen ist, ist hier nur die Endoberfläche der Feder mit einer Goldschicht von zum Beispiel bis zu 0,1 µm Dicke gemeint und nicht die ganze Feder. Allerdings ist es natürlich grundsätzlich auch möglich, die Gold-Feder ganz aus Gold zu fertigen, wenngleich darauf in Regel aus Kostengründen verzichtet wird. Aus technischer Sicht ist es auch nicht notwendig, die Feder aus massivem Gold zu fertigen.

Das Kontaktsystem Zinn-Feder auf Zinn-Leiterplattenoberfläche führt auf Grund von Reibkorrosion zu Feldausfällen, das heißt zum Versagen der Funktion des Kontaktsystems.

Das Kontaktsystem Gold-Feder auf Gold-Leiterplattenoberfläche ist staubempfindlich.

Das Kontaktsystem, welches zu einem Federkontakt einen Gegenkontakt hat, der eine Karbonschicht aufweist, hat eine geringere Leitfähigkeit als beispielsweise eine Gold- oder Silberschicht.

Bei Schaltvorgängen, bei denen lediglich ein "digitales" Schaltsignal ausgewertet werden muss und nicht etwa eine Signalintensität, spielt die geringere Leitfähigkeit des Kontaktsystems keine Rolle.

Ein solches Kontaktsystem kann daher ohne weiteres beispielsweise bei Haushaltsgeräten eingesetzt werden, bei denen mit Hilfe eines ein solches Kontaktsystem umfassenden Wahlachalters unterschiedliche Schaltzustände eingestellt werden müssen.

Sind die drei gerade erwähnten Kontaktsysteme im Zusammenhang beispielsweise mit einem Lautsprecher wie zum Beispiel einer Hörkapsel verwendet, sind auf Grund deren Nachteile Knackgeräusche oder Kontaktunterbrechungen oder zu geringe Signalintensitäten möglich.

Die US 4,625,084 A zeigt eine Drehschalteranordnung mit einer Feder, die auf einer Leiterplattenoberfläche kontaktiert, wobei die zu kontaktierende Leiterplattenoberfläche eine Karbon-Leiterplattenoberfläche ist und die Feder mit einer entsprechenden Federkraft ausgestattet ist.

Aufgabe der vorliegenden Erfindung ist es, ausgehend von einem Kontaktsystem der eingangs genannten Art, ein solches Kontaktsystem technisch in der weise zu verbessern, dass die mit solchen Kontaktsystemen zusammenhängenden Nachteile, insbesondere die im Zusammenhang mit der Verwendung von Lautsprechern auftretenden Knackgeräusche, Unterbrechungen und zu geringen Signalintensitäten, vermieden sind. Außerdem soll das verbesserte Kontaktsystem kostengünstig sein.

Gelöst wird diese Aufgabe erfindungsgemäß durch ein Kontaktsystem, das die im Kennzeichen des Anspruchs 1 angegebenen Merkmale aufweist.

Danach weist das erfindungsgemäße Kontaktsystem, das auf einer Feder basiert, die auf eine Leiterplattenoberfläche kontaktiert, eine Leiterplattenoberfläche auf, die eine Karbon-Leiterplattenoberfläche ist. Weiter weist das erfindungsgemäße Kontaktsystem elektrische und/oder elektronische Mittel auf, durch die dem Übergangswiderstand zwischen der Feder und der Karbon-Leiterplattenoberfläche Rechnung getragen ist. Schließlich ist die Feder mit einer Federkraft ausgestattet, die der Karbon-Leiterplattenoberfläche angepasst ist.

Durch den Einsatz einer Karbon-Leiterplattenoberfläche für die Kontaktierung durch eine Feder erhöht sich der Ubergangswiderstand von vormals typischerweise 20 bis 200 µOhm auf 2 bis 10 Ohm. Beispielsweise in einer Hörkapselanschaltung ist der zusätzliche Widerstand durch Anpassen der Schaltung mit entsprechenden elektrischen und/oder elektronischen Mitteln in entsprechender Weise kompensierbar.

In Kombination mit einer Feder, deren Anpressdruck an die Verhältnisse des erfindungsgemäßen Kontaktsystems angepasst ist, ist das erfindungsgemäße Kontaktsystem auf Dauer verwendbar.

Vorteil des erfindungsgemäßen Kontaktsystems ist darüber hinaus, dass beispielsweise bei einer Bedruckung einer Tastaturleiterplatte mit Karbon auch gleich beispielsweise Hörkapselkontakte mit bedruckt werden können, die nach bisherigem Herstellungsmuster mit anderen Materialien in anderen Fertigungsschritten hergestellt werden mussten. Zusätzliche Kosten entstehen so auf der Leiterplatte, verglichen beispielsweise mit einem Kontaktsystem mit einer Zinn-Feder und einer zinnLeiterplattenoberfläche, nicht.

Ein weiterer Vorteil ist, dass, soweit nicht weitere Bauteile eine Nickel/Gold-Oberfläche erfordern, gegebenenfalls ganz auf eine Nickel/Gold-Oberfläche für die Kontaktierung verzichtet werden kann.

Standzeiten des Kontaktsystems gehen bis zu 1 Million und mehr Reibzyklen, ohne dass die Stabilität des Kontaktsystems verloren geht. Im Vergleich zu einem bisher verwendeten Kontaktsystem mit Zinn-Feder und Zinn-Leiterplattenoberfläche entspricht dies einer Verbesserung um den Faktor > 1000.

Auch ist das erfindungsgemäße Kontaktsystem in Bezug auf Staub im Fertigungsprozess oder in der Anwendung robust. Während erfahrungsgemäß alle in Frage kommenden bisher verwendeten Metallkombinationen für ein bekanntes Kontaktsystem, hier jetzt wieder beispielsweise insbesondere bezüglich einer Hörkapsel-Anwendung, Knackgeräusche zeigen, bleiben diese beim erfindungsgemäßen Kontaktsystem aus. Der Unterschied ist lediglich, wie oben schon angesprochen, ein hochohmigerer Kontaktwiderstand, der sich aber, wie oben ebenfalls schon angesprochen, durch einfache technische Maßnahmen kompensieren lässt.

Vorteilhafte Ausgestaltungen der Erfindung sind Gegenstand von Unteransprüchen.

Danach wird als Feder eine Gold-Feder eingesetzt, mit der sich eine bestmögliche Qualität im Kontaktverhalten des Kontaktsystems erreichen lässt.

Als Ausführungsbeispiel sei nochmals der Einsatz des Kontaktsystems im Zusammenhang mit der Montage einer Hörkapsel auf eine entsprechende zugehörige Leiterplatte erwähnt, wobei hier jetzt speziell die Hörkapsel mit erhöhtem Federdruck arbeitenden Gold-Federn ausgestattet ist, die im montierten Zustand der Hörkapsel auf die Leiterplatte auf entsprechend zugeordnete Leiterplattenoberflächen, hier jetzt bestehend aus Karbon, drücken und dadurch kontaktieren.

## Patentansprüche

1. Kontaktsystem, umfassend eine Karbon-Leiterplattenoberfläche, eine Feder, die auf der Karbon-Leiterplattenoberfläche kontaktiert, sowie elektronische Mittel, **dadurch gekennzeichnet, dass** die Feder mit einer auf die Karbon-Leiterplattenoberfläche wirkenden erhöhten Federkraft ausgestattet ist, und dass die elektronischen Mittel eingerichtet sind, einen aufgrund der Verwendung der Karbon-Leiterplattenoberfläche zum Kontaktieren mit der Feder vorherrschenden höheren Übergangswiderstand zwischen der Feder und der Karbon-Leiterplattenoberfläche zu kompensieren.

2. Kontaktsystem nach Anspruch 1, **dadurch gekennzeichnet, dass** die Feder eine Gold-Feder oder eine goldbeschichtete Feder ist.

3. Verwendung eines Kontaktsystems nach Anspruch 1 oder 2 zur Kontaktierung eines Lautsprechers, insbesondere einer Hörkapsel.

## Claims

1. A contact system, comprising a carbon printed-circuit-board surface, a spring, which contacts on the carbon printed-circuit-board surface, as well as electronic means, **characterised in that** the spring is equipped with an elevated spring force acting on the carbon printed-circuit-board surface, and **in that** the electronic means are set up to compensate a higher contact resistance between the spring and the carbon printed-circuit-board surface prevailing because of the use of the carbon printed-circuit-board for contacting with the spring.

2. The contact system according to Claim 1, **characterised in that** the spring is a gold spring or a gold-coated spring.

3. A use of a contact system according to Claim 1 or 2 for contacting a loudspeaker, particularly an earpiece.

## Revendications

1. Système de contact, comprenant une surface en carbone de carte de circuits imprimés, un ressort qui établit un contact sur la surface en carbone de carte de circuits imprimés, ainsi que des moyens électroniques,
**caractérisé en ce que** le ressort est doté d'une force élastique accrue s'exerçant sur la surface en carbone de carte de circuits imprimés et **en ce que** les moyens électroniques sont établis pour compenser une résistance de contact supérieure, qui prévaut en raison de l'utilisation de la surface en carbone de carte de circuits imprimés pour l'établissement de contact avec le ressort, entre le ressort et la surface en carbone de carte de circuits imprimés.

2. Système de contact selon la revendication 1, **caractérisé en ce que** le ressort est en ressort en or ou un ressort revêtu d'or.

3. Utilisation d'un système de contact selon la revendication 1 ou 2 pour l'établissement de contact d'un haut-parleur, en particulier d'un écouteur.
